# EUROPÄISCHE PATENTSCHRIFT

(11) **EP 4 343 828 B1**
(45) Veröffentlichungstag und Bekanntmachung des Hinweises auf die Patenterteilung: **09.04.2025**
(21) Anmeldenummer: 23198522.7
(22) Anmeldetag: 20.09.2023
(51) Int. Cl.: H01L 23/373, H01L 25/07, H01L 25/065, H05K 1/02, H01L 23/538, H01L 23/433, H01L 23/40, H01L 21/56, H01L 23/051, H01L 25/11, H05K 3/28

(54) **LEITERPLATTENANORDNUNG UND VERFAHREN ZUR HERSTELLUNG EINER LEITERPLATTENANORDNUNG**
PRINTED CIRCUIT BOARD ARRANGEMENT AND METHOD FOR PRODUCING A PRINTED CIRCUIT BOARD ARRANGEMENT
ENSEMBLE CARTE DE CIRCUIT IMPRIMÉ ET PROCÉDÉ DE FABRICATION D'UN ENSEMBLE CARTE DE CIRCUIT IMPRIMÉ

(30) Priorität: 23.09.2022 DE 102022124513
(43) Veröffentlichungstag der Anmeldung: 27.03.2024
(73) Patentinhaber: Rolls-Royce Deutschland Ltd & Co KG, 15827 Blankenfelde-Mahlow (DE)
(72) Erfinder: WALTRICH, Uwe, 15827 Blankenfelde-Mahlow (DE)

(56) Entgegenhaltungen:
- JP-A- 2015 211 600
- US-A1- 2020 203 301
- US-A1- 2021 233 830

## Beschreibung

Die Erfindung betrifft eine Leiterplattenanordnung gemäß dem Oberbegriff des Patentanspruchs 1 und ein Verfahren zur Herstellung einer solchen Leiterplattenanordnung.

Es ist bekannt, leiterplattenbasierte Leistungselektronikbaugruppen zur Kühlung an einen Kühlkörper mittels Schraubverbindungen anzupressen, wobei die zu kühlenden Bauteile typischerweise als oberflächenmontierte (SMD-) Bauteile (SMD = "Surface-mounted device") oder in Durchsteckmontage (THT = "Through-Hole-Technology") ausgeführt sind und auf der Unterseite der Leiterplatte sitzen. Die zu kühlenden Bauteile umfassen ein eingebettetes Halbleiterbauelement und werden auch als Prepackage-Module oder - in der vorliegend verwendeten Terminologie - als elektrische Module bezeichnet.

Je nach Leistungsklasse werden eine hohe Anzahl an zu kühlenden Prepackage-Modulen auf der Unterseite der Leiterplatte angeordnet und zur Kühlung an einen Kühlkörper gepresst. Dabei gilt, dass jeder Spalt zwischen dem zu kühlenden elektrischen Modul und dem Kühlkörper zu einer Verschlechterung der thermischen Anbindung des elektrischen Moduls an den Kühlkörper führt. Ein Spalt zwischen einem zu kühlenden Modul und dem Kühlkörper sollte daher minimiert werden. Bei mehreren elektrischen Modulen, die gekühlt werden müssen, können Spalte mit unterschiedlichen Spaltmaßen zum Kühlkörper vorliegen, die auszugleichen sind. Weitere Toleranzen in den Spaltmaßen ergeben sich aus einer Dickentoleranz der Leiterplatte, lokalen thermischen Durchbiegungen der Leiterplatte und Unebenheiten in der Kühlkörperoberfläche.

Zum Ausgleich dieser Höhentoleranzen ist es bekannt, Wärmeleitmaterialien einzusetzen. In der Leistungselektronik kommen Pastensysteme oder Folien zum Einsatz, die auf die Kühlfläche appliziert werden und minimale Spalte und Rauheiten bis zu 100 µm ausgleichen. Allerdings liegt ein effektiver Wärmetransport in den Kühlkörper nur im Bereich der elektrischen Module vor, da diese gegen den Kühlkörper gepresst werden und der thermische Widerstand sich bei erhöhtem mechanischen Druck verringert.

JP 2015 211600 A beschreibt eine Leistungsumwandlungsvorrichtung umfassend ein Halbleitermodul, einen Kühler zum Kühlen des Halbleitermoduls, ein Steuersubstrat, das mit dem Halbleitermodul verbunden ist, einen Anschluss zum Verbinden des Halbleitermoduls und des Steuersubstrats, und eine Sammelschiene zum Verbinden des Halbleitermoduls mit einem Eingangsanschluss und einem Ausgangsanschluss, wobei wenigstens eine von einer C-Ebene, einer S-Ebene und einer lateralen Fläche hergestellt ist, um ein Verstärkungselement zu kontaktieren und an dem Verstärkungselement fixiert zu sein.

US 2020/203301 A1 beschreibt eine Gehäusestruktur umfassend mindestens einen Halbleiterchip, eine Vielzahl von Hohlzylindern, ein isolierendes Einkapselungsmittel, eine Umverteilungsschicht und Durchgangslöcher. Die Vielzahl von Hohlzylindern umgibt den mindestens einen Halbleiterchip. Das isolierende Einkapselungsmittel weist eine obere Oberfläche und eine untere Oberfläche gegenüber der oberen Oberfläche auf, wobei das isolierende Einkapselungsmittel den mindestens einen Halbleiterchip und die Vielzahl von Hohlzylindern einkapselt. Die Umverteilungsschicht ist auf der oberen Oberfläche des isolierenden Verkapselungsmittels und über dem mindestens einen Halbleiterchip angeordnet. Die Durchgangslöcher durchdringen die Vielzahl von Hohlzylindern.

Der vorliegenden Erfindung liegt die Aufgabe zu Grunde, eine Leiterplattenanordnung bereitzustellen, die eine verbesserte thermische Anbindung eines elektrischen Moduls an einen Kühlkörper bereitstellt, sowie ein Verfahren zur Herstellung einer solchen Leiterplattenanordnung anzugeben.

Diese Aufgabe wird durch eine Leiterplattenanordnung mit den Merkmalen des Anspruchs 1 und ein Verfahren mit den Merkmalen des Anspruchs 12 gelöst. Ausgestaltungen der Erfindung sind in den abhängigen Ansprüchen angegeben.

Danach betrachtet die Erfindung in einem ersten Erfindungsaspekt eine Leiterplattenanordnung, die eine Leiterplatte mit einer Oberseite und einer Unterseite, mindestens ein auf der Unterseite der Leiterplatte angeordnetes elektrisches Modul, einen Kühlkörper, Mittel zur Bereitstellung eines Drucks, mit dem das elektrische Modul mit seiner Unterseite gegen den Kühlkörper gedrückt wird, und ein Wärmeleitmaterial aufweist, wobei das Wärmeleitmaterial zwischen der Unterseite des elektrischen Moduls und dem Kühlkörper angeordnet ist.

Es ist vorgesehen, dass das mindestens eine elektrische Modul in ein Vergussmaterial eingebettet ist, das mit der Unterseite des elektrischen Moduls abschließt, ohne die Unterseite zu bedecken, wobei das Vergussmaterial dazu vorgesehen und ausgebildet ist, angrenzend an das mindestens eine elektrische Modul das Wärmeleitmaterial gegen den Kühlkörper zu drücken.

Die erfindungsgemäße Lösung beruht auf dem Gedanken, die thermische Ankopplung eines elektrischen Moduls an einen Kühlkörper zu verbessern, indem ein Vergussmaterial, in das das elektrische Modul eingegossen ist, die Wärmeleitfolie seitlich des elektrischen Moduls zusätzlich gegen den Kühlkörper drückt, so dass der thermische Übergang zum Kühlkörper auf einer vergrößerten Kühlkörperoberfläche erfolgt.

Der erfindungsgemäßen Lösung liegt dabei die Erkenntnis zugrunde, dass der thermische Übergang zum Kühlkörper stark vom Anpressdruck an den Kühlkörper abhängt. In herkömmlichen Leiterplattenanordnungen ist der Anpressdruck nur im Bereich der zu kühlenden elektrischen Module hoch, die gegen den Kühlkörper gepresst werden. Neben den elektrischen Modulen liegt das Wärmeleitmaterial dagegen ohne einen Anpressdruck lediglich auf der Kühlkörperoberfläche auf, so dass der Wärmetransport in den Kühlkörper in diesen Bereichen gering ist. Durch Einbetten des elektrischen Moduls bzw. einer Mehrzahl elektrischer Module in ein Vergussmaterial kann auch neben dem elektrischen Modul und zwischen den einzelnen elektrischen Modulen das Wärmeleitmaterial gegen die Kühlkörperoberfläche gepresst werden. Auf diese Weise wird der thermische Übergang zum Kühlkörper insgesamt verbessert.

Die erfindungsgemäße Lösung erreicht somit eine Verbesserung der Wärmeverteilung über die Oberfläche des Kühlkörpers und damit eine verbesserte Kühlung der elektrischen Module. Dies wiederum erlaubt es, kleinere Kühlsysteme einzusetzen.

Es wird darauf hingewiesen, dass im Sinne der vorliegenden Erfindung stets diejenige Seite der Leiterplatte, an der ein zu kühlendes elektrisches Modul angeordnet ist, als Unterseite der Leiterplatte bezeichnet wird, unabhängig von der tatsächlichen Orientierung der Leiterplatte und des elektrischen Moduls im Raum.

Sofern die Leiterplattenanordnung mehrere elektrische Module aufweist, kann vorgesehen sein, dass diese gemeinsam in ein Vergussmaterial eingebettet sind, wobei das Vergussmaterial im Bereich zwischen den elektrischen Modulen das Wärmeleitmaterial gegen den Kühlkörper drückt.

Das Vergussmaterial erstreckt sich in Ausgestaltungen der Erfindung zumindest abschnittsweise bis an die Unterseite der Leiterplatte, so dass der offene Raum zwischen dem Wärmeleitmaterial und der Unterseite der Leiterplatte vollständig oder zumindest teilweise mit dem Vergussmaterial gefüllt ist. Hierdurch wird eine verbesserte Kühlung aller Bauteile der Leiterplatte durch eine vollflächige Anbindung der Leiterplatte an den Kühlkörper erreicht.

Darüber hinaus erlaubt diese Ausgestaltung eine partielle elektrische Isolation von kritischen Bereichen auf der Unterseite der Leiterplatte bzw. im Bereich zwischen dem elektrischen Modul und der Leiterplatte. In diesem Zusammenhang ist zu beachten, dass die Anordnung der elektrischen Module an der Leiterplatte bzw. an einer Trägerplatine über einen Lötprozess erfolgt, bei dem einander zugeordnete Lotpads auf dem elektrischen Modul und auf der Leiterplatte über eine Lotschicht miteinander verbunden werden. Dabei entsteht prinzipbedingt ein Luftspalt zwischen dem elektrischen Modul und der Leiterplatte. Dieser Luftspalt wird herkömmlich in einem Underfill-Prozess mit einem Isolationsmaterial vergossen, das unter anderem vor Teilentladungen schützt und die Einhaltung von Luft- und Kriechstrecken ermöglicht. Fertigungsseitig ist die Applikation eines Underfill-Materials allerdings herausfordernd. Das Material wird neben dem elektrischen Modul appliziert und kriecht dann aufgrund der Kapillarwirkung in den Spalt hinein. Hierbei ist die Qualität der Underfill-Schicht im Hinblick auf eine erforderliche Blasenfreiheit von zahlreichen Faktoren abhängig, wie der Sauberkeit des Spalts, der Spalthöhe, der Spaltgeometrie und der verwendeten Oberflächen.

Die erfindungsgemäße Lösung erlaubt es, einen Underfill-Prozess zu vermeiden und den Spalt zwischen der Oberseite des elektrischen Moduls und der Unterseite der Leiterplatte stattdessen durch das Vergussmaterial zu füllen. So sieht eine Ausgestaltung der Erfindung vor, das elektrische Modul an seiner Oberseite ausgebildete elektrische Lotpads aufweist, die jeweils über eine Lotschicht mit einem zugeordneten elektrischen Lotpad der Leiterplatte in Kontakt stehen, wobei das Vergussmaterial sich angrenzend an die Lotpads auch im Spalt zwischen der Unterseite der Leiterplatte und der Oberseite des elektrischen Moduls erstreckt. Ein Underfill-Material wird somit durch das Vergussmaterial ersetzt. Hierdurch wird das Risiko einer Blasenbildung im Spalt zwischen dem elektrischen Modul und der Leiterplatte verringert, da das Vergussmaterial jeweils in Ausgestaltungen der Erfindung deutlich spaltgängiger ist und zudem mit hohem Druck eingespritzt werden kann, beispielsweise durch Spritzpressen, wie noch ausgeführt wird.

Eine weitere Ausgestaltung sieht vor, dass das Vergussmaterial des Weiteren solche Bereiche an der Unterseite der Leiterplatte umgibt und elektrisch isoliert, in denen die Leiterplatte Durchkontaktierungen ausbildet. Hierzu wird zum Hintergrund angemerkt, dass die elektrischen Kontakte auf der Leiterplatte typischerweise über Durchkontaktierungen bzw. Vias in der Leiterplatte mit Spannung beaufschlagt werden. Mit solchen Durchkontaktierungen versehene Kontaktflächen der Leiterplatte sind elektrisch zu isolieren. Bei Verwendung eines Underfill-Materials kann dieses aufgrund seiner Vernetzungseigenschaften nicht exakt auf die Leiterplatte und damit auf die zu isolierenden Flächen aufgetragen werden. Dies führt dazu, dass zum Beispiel mittels eines sogenannten "Dam & Fill"-Prozesses weitere Prozessschritte mit einem zusätzlichen Material auszuführen sind, um die Durchkontaktierungen zu isolieren, wobei das zusätzliche Material eine Grenzschicht zum Underfill-Material bildet.

Die erfindungsgemäße Lösung vermeidet diese Probleme, indem das Vergussmaterial zusätzlich zur Isolation solcher Bereiche an der Unterseite der Leiterplatte dient, in denen die Leiterplatte Durchkontaktierungen ausbildet. Das Vergussmaterial wird somit zur partiellen Isolation von kritischen Bereichen auf der Leiterplatte eingesetzt.

Eine Ausgestaltung der Erfindung sieht vor, dass das Vergussmaterial eine Härte aufweist, die größer ist als die Härte des Wärmeleitmaterials, so dass es das Wärmeleitmaterial effektiv gegen den Kühlkörper pressen kann. Dabei kann vorgesehen sein, dass das Vergussmaterial als Hartverguss ausgebildet ist.

Es handelt sich bei dem Vergussmaterial in Ausführungsbeispielen um einen duroplastischen Kunststoff. Beispielsweise handelt es sich bei dem Vergussmaterial um ein Epoxidharz. Ein Zweikomponenten-Epoxid besteht aus einem Polymerharz und einem Härter, die chemisch miteinander reagieren. Eine Epoxid-Vergussmasse zeichnet sich durch eine hohe Steifigkeit und Zugfestigkeit, eine hohe Temperaturbeständigkeit und eine geringe Schrumpfung aus. Auch besitzt sie eine hohe elektrische Durchschlagsfestigkeit.

Eine weitere Ausgestaltung der Erfindung sieht vor, dass das mindestens eine elektrische Modul durch Spritzpressen oder Spritzgießen in das Vergussmaterial eingebettet worden ist. Diese Verfahren erlauben es, das elektrische Modul unter Druck in definierter Weise zu umspritzen, wobei das zu umspritzende Volumen exakt definiert werden kann. Dabei können auch bestimmte Bereiche der Leiterplattenanordnung mit Vergussmaterial befüllt und partiell isoliert werden, wie beispielsweise der Spalt zwischen dem elektrischen Modul und der Leiterplatte sowie Via-Bereiche an der Leiterplatte.

Das elektrische Modul ist in Ausführungsbeispielen derart aufgebaut, dass es umfasst:
- einen keramischen Schaltungsträger, der eine isolierende Keramikschicht und eine auf der Oberseite der Keramikschicht angeordnete Metallisierungsschicht aufweist, und
- ein elektrisches Bauelement, das auf der Oberseite der Metallisierungsschicht angeordnet und elektrisch mit dieser verbunden ist,
- wobei die Keramikschicht oder eine auf der Unterseite der Keramikschicht ausgebildete zweite Metallisierungsschicht über das Wärmeleitmaterial mit dem Kühlkörper verbunden ist.

Derartige keramische Schaltungsträger dienen der elektrischen Isolation des mit dem keramischen Schaltungsträger verbundenen elektrischen Bauelements zum Kühlkörper und gleichzeitig der thermischen Anbindung an den Kühlkörper.

Bei dem in das elektrische Modul integrierten elektrischen Bauelement kann es sich um ein Halbleiterbauelement, insbesondere einen Leistungshalbleiter wie z.B. einen Leistungs-MOSFET oder ein IGBT-Bauelement handeln. Es handelt sich beispielsweise um einen Leistungshalbleiter eines Wechselrichters oder allgemein eines Stromrichters, der für den Betrieb eines Elektromotors vorgesehen ist.

Weiter kann vorgesehen sein, dass elektrische Kontakte des Moduls mindestens eine erste Durchkontaktierung umfassen, die sich von einem Lotpad an der Oberseite bis zu der ersten Metallisierungsschicht erstreckt, sowie zweite und dritte Durchkontaktierungen umfassen, die sich von anderen Lotpads an der Oberseite zu entsprechenden Kontakten an der Oberseite des elektrischen Bauelements erstrecken. Hierdurch wird eine Kontaktierung des elektrischen Bauelements über an der Oberseite des elektrischen Moduls angeordnete Kontakte ermöglicht.

Eine weitere Ausgestaltung sieht vor, dass das mindestens eine elektrische Modul in einer Kavität des Kühlkörpers angeordnet ist.

In einem weiteren Erfindungsaspekt betrifft die vorliegende Erfindung auch ein Verfahren zur Herstellung einer Leiterplattenanordnung. Das Verfahren umfasst die Schritte:
- Anordnen und elektrisches Kontaktieren mindestens eines elektrischen Moduls an der Unterseite einer Leiterplatte,
- Einlegen der Leiterplatte mit dem mindestens einen elektrischen Modul in ein Werkzeug,
- Anlegen eines Stempels mit einer Ausgleichsfolie an die Unterseite des mindestens einen elektrischen Moduls und Drücken der Ausgleichsfolie gegen die Unterseite,
- Schließen des Werkzeugs,
- Einspritzen einer Formmasse in das Werkzeug, wobei das mindestens eine elektrische Modul umspritzt wird, ohne dass die mit der Ausgleichsfolie bedeckte Unterseite des elektrischen Moduls mit der Formmasse bedeckt wird,
- Aushärten der Formmasse unter Entstehung einer Vergussmasse,
- Entnahme der Leiterplatte mit dem mit der Vergussmasse umgossenen mindestens einen elektrischen Modul aus dem Werkzeug, und
- thermisches Koppeln des mindestens einen elektrischen Moduls mit einem Kühlkörper unter Verwendung eines Wärmeleitmaterials und von Mitteln zur Bereitstellung eines Drucks, wobei das Vergussmaterial angrenzend an das mindestens eine elektrische Modul das Wärmeleitmaterial gegen den Kühlkörper drückt.

Dieser Erfindungsaspekt stellt ein robustes und definiertes Verfahren zur Isolation und Umspritzung von elektrischen Modulen und anderen Leiterplattenbereichen bereit.

Das Einspritzen einer Formmasse in das Werkzeug erfolgt dabei beispielsweise durch Spritzpressen oder Spritzgießen.

Eine Ausgestaltung sieht vor, dass beim Einspritzen der Formmasse in das Werkzeug das mindestens eine elektrische Modul dahingehend umspritzt wird, dass die Formmasse auch einen Spalt zwischen der Unterseite der Leiterplatte und der Oberseite des elektrischen Moduls schließt (bis auf jene Bereiche, in denen wie erläutert elektrische Lotpads und Lotschichten ausgebildet sind).

Weiter kann vorgesehen sein, dass beim Einspritzen der Formmasse in das Werkzeug das mindestens eine elektrische Modul dahingehend umspritzt wird, dass die Formmasse auch solche Bereiche an der Unterseite der Leiterplatte umgibt und elektrisch isoliert, in denen die Leiterplatte Durchkontaktierungen ausbildet.

Weitere Ausführungsvarianten sehen vor, dass das Verfahren im Nutzen eingesetzt wird, wobei eine Mehrzahl von elektrischen Modulen im Werkzeug gleichzeitig umspritzt wird.

Die Erfindung wird nachfolgend unter Bezugnahme auf die Figuren der Zeichnung anhand mehrerer Ausführungsbeispiele näher erläutert. Es zeigen:
- Figur 1: schematisch ein Ausführungsbeispiel einer Leiterplattenanordnung, die ein an einer Leiterplatte angeordnetes elektrisches Modul umfasst, wobei das elektrische Modul in ein Vergussmaterial eingebettet ist, das ein Wärmeleitmaterial gegen einen Kühlkörper drückt;
- Figur 1a: einen Ausschnitt der Leiterplattenanordnung der Figur 1;
- Figur 2: eine Leiterplattenanordnung gemäß der Figur 1, wobei zusätzliche Details im Hinblick auf das elektrische Modul dargestellt sind;
- Figur 3: ein Beispiel einer nicht erfindungsgemäßen Leiterplattenanordnung, die ein an einer Leiterplatte angeordnetes elektrisches Modul umfasst;
- Figur 4: schematisch die Einbettung zweier elektrischer Module in ein Vergussmaterial in einer nicht erfindungsgemäßen Weise, bei der die Unterseite des elektrischen Moduls mit dem Vergussmaterial bedeckt ist;
- Figur 5: ein Werkzeug zur Herstellung einer Leiterplattenanordnung gemäß der Figur 1;
- Figur 6: ein elektrisches Modul einer Leiterplattenanordnung gemäß der Figur 1, wobei die Unterseite des elektrischen Moduls an ihren Rändern einen vertikalen Versatz zum Vergussmaterial aufweist, in das das elektrische Modul eingebettet ist; und
- Figur 7: ein Ablaufdiagramm eines Verfahrens zur Herstellung einer Leiterplattenanordnung gemäß der Figur 1.

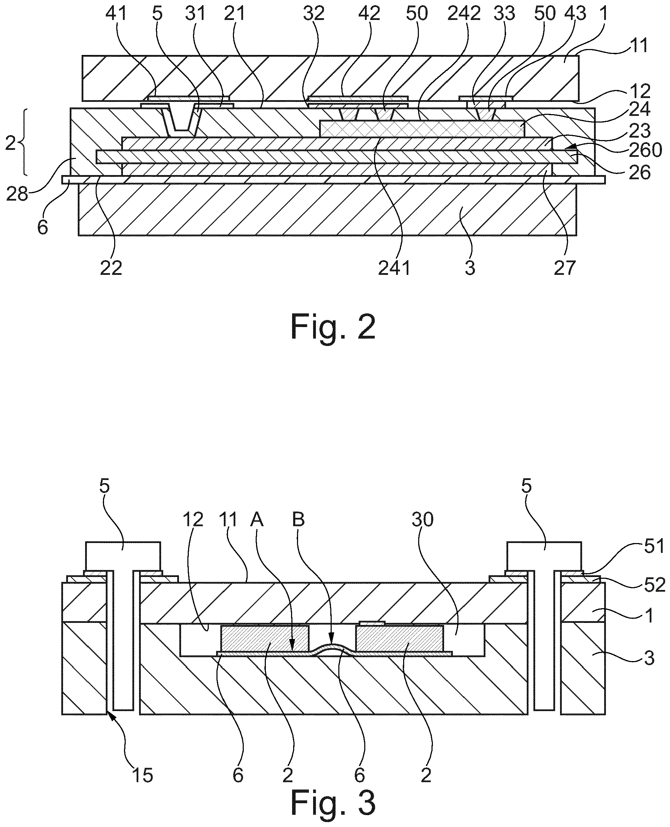

Zum besseren Verständnis des Hintergrunds der vorliegenden Erfindung wird anhand der Figur 3 zunächst eine nicht erfindungsgemäße Leiterplattenanordnung beschrieben.

Die Figur 3 zeigt eine Leiterplattenanordnung, die eine Leiterplatte 1 und einen Kühlkörper 3 umfasst. Die Leiterplatte 1 besteht aus einer Vielzahl von Leiterplattenlagen (nicht gesondert dargestellt), die übereinander angeordnet sind. Sie weist eine Oberseite 11 und eine Unterseite 12 auf.

Auf der Unterseite 12 der Leiterplatte 1 sind elektrische Module 2 angeordnet. Die Verbindung mit der Leiterplatte 1 erfolgt beispielsweise über eine Oberflächenmontage. Dies ist jedoch lediglich beispielhaft zu verstehen. Zusätzlich können auch an der Oberseite 11 der Leiterplatte 1 elektrische Bauteile angeordnet sein. Von Interesse im vorliegenden Kontext sind die an der Unterseite 12 angeordneten elektrischen Module 2, bei denen es sich um aktive Bauteile handelt (beispielsweise Module der Leistungselektronik), die einer Kühlung durch einen Kühlkörper 3 bedürfen. Hierzu weist der Kühlkörper 3 eine Aussparung 30 auf, in die die zu kühlenden Module 2 hineinragen, wobei die zu kühlenden Module 2 an ihrer Unterseite in thermischen Kontakt mit dem Kühlkörper 3 gelangen.

Hierbei ist es nachteilig, wenn ein Spalt zwischen dem jeweiligen Modul 2 und dem Kühlkörper 3 vorhanden ist, da ein solcher Spalt die thermische Anbindung an den Kühlkörper 3 verschlechtert. Zur Verbesserung der thermischen Anbindung ist zwischen den zu kühlenden Modulen 2 und dem Kühlkörper 3 ein Wärmeleitmaterial 6 angeordnet.

Die Leiterplatte 1 ist über Metallschrauben 5 mit dem Kühlkörper 3 verschraubt. Die Metallschrauben 3 sind in Durchgangsbohrungen 15 eingeschraubt, die sich von der Leiterplatte 1 in den Kühlkörper 3 erstrecken. Die Metallschrauben 3 liegen über eine Unterlegscheibe 51 und eine Metallisierung 52 auf der Oberseite 11 der Leiterplatte 1 auf. Sie stellen eine Druckkraft bereit, mit der die Leiterplatte 1 gegen den Kühlkörper 3 gepresst wird. Insbesondere stellen Sie dabei die Druckkraft bereit, mit der die an der Unterseite 12 der Leiterplatte 1 angeordneten zu kühlenden elektrischen Module 2 über das Wärmeleitmaterial 6 an die Oberfläche des Kühlkörpers 3 zur Bereitstellung eines guten thermischen Übergangs angepresst werden.

Der Kühlkörper 3 kann zahlreiche Ausgestaltungen aufweisen. Er besteht beispielsweise aus einem Metall wie zum Beispiel Aluminium oder einer Aluminiumlegierung und weist nicht gesondert dargestellte Kühlflächen auf. Es handelt sich bei dem Kühlkörper 3 beispielsweise um einen aktiven Kühlkörper, der durch einen Lüfter (nicht dargestellt) oder mittels einer Flüssigkeitskühlung (nicht dargestellt) aktiv gekühlt wird. Alternativ ist der Kühlkörper 3 als passiver Kühlkörper ausgebildet.

In alternativen Ausgestaltungen (nicht dargestellt) kann vorgesehen sein, dass zur Verbesserung des thermischen Kontaktes zwischen dem zu kühlenden Modul 2 und dem Kühlkörper 3 zusätzlich ein Niederhalter eingesetzt wird, der die Leiterplatte gegen den Kühlkörper drücken.

Das Wärmeleitmaterial 6 wird in den Bereichen A unterhalb der elektrischen Modul 2 aufgrund der durch die Schrauben 5 bereitgestellten Druckkraft mit hohem mechanischen Druck gegen den Kühlkörper 3 gedrückt. In Bereichen B zwischen den einzelnen elektrischen Modulen 2 bzw. angrenzend an das jeweilige elektrische Modul 2 liegt das Wärmeleitmaterial 2 jedoch lediglich auf. Dies ist in der Figur 3 nicht maßstabsgerecht durch eine Verwölbung des Wärmeleitmaterials 2 angedeutet. Dementsprechend liegt kein oder ein nur geringer mechanischer Druck auf das Wärmeleitmaterial 2 angrenzend an die elektrischen Module 2 vor. Somit besteht in diesen Bereichen auch ein lediglich reduzierter Wärmetransport aus dem Wärmeleitmaterial 2 in den Kühlkörper 3.

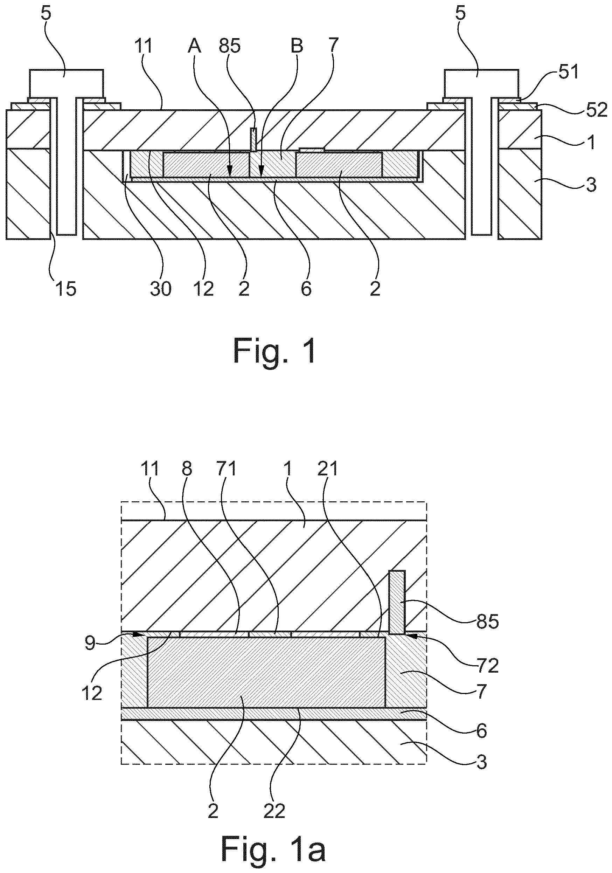

Die Figur 1 zeigt ein Ausführungsbeispiel einer Leiterplattenanordnung. Der grundlegende Aufbau ist dabei der gleiche wie in Bezug auf die Figur 3 erläutert, so dass auf die Erläuterungen zur Figur 3 ergänzend Bezug genommen wird. Gemäß der Figur 1 ist vorgesehen, dass die dargestellten elektrischen Module 2 in ein Vergussmaterial 7 eingebettet sind. Das Vergussmaterial 7 schließt dabei mit der Unterseite des elektrischen Moduls ab, ohne die Unterseite zu bedecken. Das Vergussmaterial 7 bewirkt, dass das Wärmeleitmaterial 7 auch in Bereichen B, die an die elektrischen Module 2 angrenzen bzw. zwischen den elektrischen Modulen 2 liegen, mit einem hohen mechanischen Druck gegen den Kühlkörper 3 gedrückt wird. Ein hoher mechanischer Druck liegt sowohl in den Bereichen A unterhalb der elektrischen Module 2 und in den Bereichen B zwischen bzw. neben den elektrischen Modulen 2 vor.

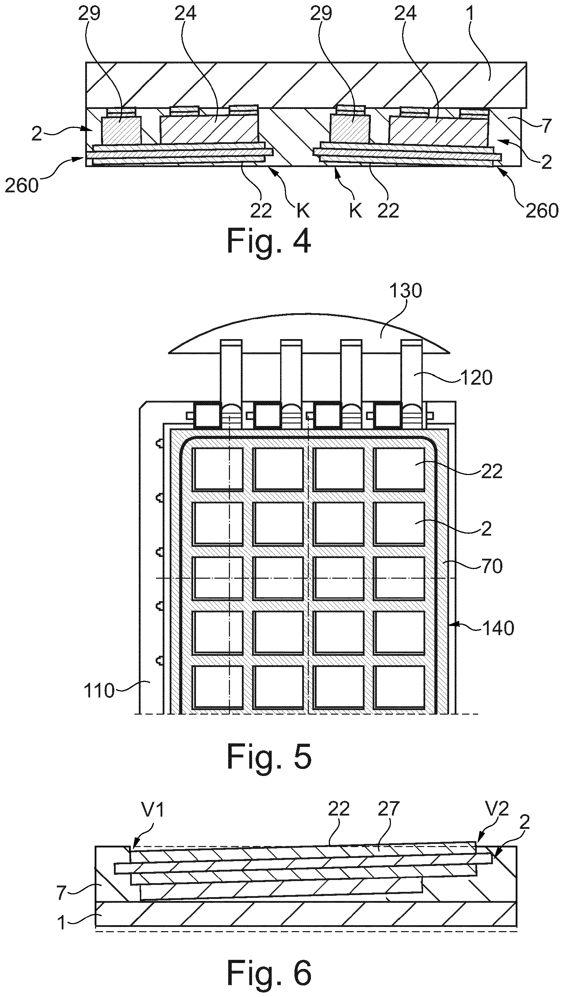

Dabei ist vorgesehen, dass das Vergussmaterial 7 als Hartverguss ausgebildet ist, der eine größere Härte als das Wärmeleitmaterial aufweist. Es handelt sich bei dem Vergussmaterial 7 beispielsweise um ein Epoxidharz oder um einen anderen Duroplast. Die Einbettung der elektrischen Module 2 in das Vergussmaterial 7 erfolgt beispielsweise durch Spritzpressen oder Spritzgießen, wie in Bezug auf die Figuren 5 bis 7 erläutert wird.

Das Wärmeleitmaterial 7 wird beispielsweise durch eine Wärmeleitfolie, eine Wärmeleitmatte oder ein Wärmeleitpaste gebildet. Dabei kann vorgesehen sein, dass eine anisotropen Wärmeleitfolie, beispielsweise eine Graphitfolie eingesetzt wird, die in der Ebene eine größere Wärmeleitfähigkeit aufweist als in vertikaler Richtung. Die Verwendung einer anisotropen Wärmeleitfolie ermöglicht, die von dem elektrischen Modul 2 ausgehende Wärme in der Fläche zu spreizen. Durch den erfindungsgemäß hohen Anpressdruck auch in den Bereichen B kann die gespreizte Wärme über die gesamte Kühlkörperoberfläche in den Kühlkörper 3 geleitet werden. Dabei sieht eine Ausführungsvariante vor, dass ein Wärmeleitmaterial mit einer hohen thermischen Leitfähigkeit in der Ebene im Bereich zwischen als 200 W/mK und 1000 W/mK eingesetzt wird.

Wie im Folgenden anhand der Detailansicht der Figur 1a erläutert wird, die einen Teilbereich der Leiterplattenanordnung der Figur 1 im Bereich eines elektrischen Moduls 2 zeigt, dient das Vergussmaterial 7 auch dazu, kritische Bereiche zwischen dem elektrischen Modul 2 und der Leiterplatte 1 sowie auf der Leiterplatte 1 elektrisch zu isolieren.

So füllt das Vergussmaterial 7 auch einen Spalt 9, der sich zwischen der Oberseite 21 des elektrischen Moduls 2 und der Unterseite 12 der Leiterplatte 1 erstreckt. In dem Spalt 9 befinden sich ferner elektrische Kontakte 8, über die das elektrische Modul 2 elektrisch und mechanisch mit der Unterseite 12 der Leiterplatte 1 verbunden ist. Wie in Bezug auf die Figur 2 erläutert wird, umfassen diese elektrischen Kontakte 8 typischerweise jeweils ein Lotpad an der Oberseite des elektrischen Moduls, eine Lotschicht und ein Lotpad an der Unterseite der Leiterplatte.

Das Vergussmaterial 7 erstreckt sich im Spalt 9 in Bereichen 71 angrenzend an die elektrischen Kontakte 8 zwischen der Unterseite 12 der Leiterplatte 1 und der Oberseite 21 des elektrischen Moduls 2. Es ersetzt dabei ein Underfill-Material, das mittels eines Underfill-Prozesses in den Spalt 9 eingebracht werden müsste. Hierdurch wird das Risiko einer Blasenbildung im Spalt 9 zwischen dem elektrischen Modul 2 und der Leiterplatte 1 verringert.

Des Weiteren umgibt und isoliert das Vergussmaterial 7 auch einen Bereich 72 an der Unterseite 12 der Leiterplatte 1, in dem die Leiterplatte Durchkontaktierungen 85 ausbildet. Dabei zeigen die Figuren 1, 1a schematisch und beispielhaft lediglich eine solche Durchkontaktierung 85. Die Durchkontaktierungen 85 dienen beispielsweise der Beaufschlagung von Lotpads an der Unterseite der Leiterplatte 1 mit Hochspannung.

Es wird darauf hingewiesen, dass die dargestellte Anzahl von zwei elektrischen Modulen 2 in der Figur 1 lediglich beispielhaft zu verstehen ist. Insbesondere können zwei oder mehr Reihen von elektrischen Modulen hintereinander (senkrecht zur Zeichenebene) vorgesehen sein.

Es wird weiter darauf hingewiesen, dass sich das Vergussmaterial 7 bis an der Unterseite 12 der Leiterplatte 1 erstreckt, die Aussparung 30 im Kühlkörper 3 somit im Wesentlichen vollständig ausfüllt (abgesehen von möglicherweise randseitigen Bereichen, in denen die Aussparung 30 nicht mit Vergussmaterial ausgefüllt ist). Dies führt dazu, dass auch von anderen, nicht dargestellten elektrischen Komponenten der Leiterplatte ausgehende Wärme über die Leiterplatte 1, das Vergussmaterial 7 und das Wärmeleitmaterial 6 in den Kühlkörper 7 abgeleitet werden kann.

Die Unterseite 22 des elektrischen Moduls 2 drückt ebenso wie die untere Fläche des Vergussmaterials 7 auf das Wärmeleitmaterial 6.

Die elektrischen Module 2 der Figur 1 können in Ausführungsbeispielen gemäß der Figur 2 ausgebildet sein. Das elektrische Modul 2 weist danach eine Oberseite 21 und eine Unterseite 22 auf. Es umfasst einen keramischen Schaltungsträger 260, ein elektrisches Bauelement 24 und elektrische Kontakte 31, 32, 33, die auf der Oberseite 21 des Moduls 2 angeordnet sind. Der keramischen Schaltungsträger 260 umfasst eine isolierende Keramikschicht 26, eine auf der Oberseite der Keramikschicht 26 angeordnete Metallisierungsschicht 23 und eine auf der Unterseite der Keramikschicht 26 angeordnete weitere Metallisierungsschicht 27. Die Keramikschicht 26 besteht beispielsweise aus Aluminiumnitrid (AIN) oder Siliziumnitrid (Si₃N₄). Die Metallisierungsschichten 23, 27 bestehen beispielsweise aus Kupfer, Aluminium, Silber oder Wolfram.

Auf der Metallisierungsschicht 23 ist über eine Lotschicht (nicht gesondert dargestellt) das elektrisches Bauelement 24 angeordnet. Das Bauelement 24 weist dabei eine Unterseite 241, mit der es auf der Metallisierungsschicht 23 angeordnet ist, und eine Oberseite 242 auf. Die Oberseite 242 und die Unterseite 241 können metallisiert, zum Beispiel verkupfert sein. Bei dem elektrischen Bauelement 24 handelt es sich beispielsweise um einen Leistungshalbleiter, der als Chip ausgebildet ist.

Der keramischen Schaltungsträger 260 und das elektrische Bauelement 24 sind in einem Substrat 28 angeordnet, das die Außenmaße des elektrischen Moduls 2 definiert. Bei dem Substrat 28 handelt es sich in einer Ausführungsvariante um eine Vergussmasse, in die der keramischen Schaltungsträger 260 und das elektrische Bauelement 24 eingebettet sind. Alternativ handelt es sich bei dem Substrat 28 um eine Leiterplatte, für welchen Fall der keramischen Schaltungsträger 260 und das elektrische Bauelement 24 in einem Leiterplattenembeddingprozess in eine Leiterplatte eingebettet worden sind.

Das Substrat 28 umfasst eine Oberseite, die auch die Oberseite 21 des Moduls 2 bildet. Die Unterseite des Substrat 28 verläuft bündig mit der unteren Metallisierungsschicht 27, die die Unterseite 22 des Moduls 2 bildet. Der keramische Schaltungsträger 260 ist mit der unteren Metallisierungsschicht 27 über ein Wärmeleitmaterial 6 mit einem Kühlkörper 3 verbunden. Über den Kühlkörper 3 wird Verlustwärme des elektrischen Bauelements 24 abgeführt.

Die elektrische Kontakte 31, 32, 33 an der Oberseite 21 des Moduls werden durch Lotpads bereitgestellt. Die Lotpads 31, 32, 33 sind über Lotverbindungen mit den Lotpads 41, 42, 43 der Leiterplatte 1 elektrisch verbunden. Dabei werden über das Lotpad 31 beispielsweise ein Drain-Anschluss und über die Lotpads 32, 33 ein Source-Anschluss und ein Gate-Anschluss des elektrischen Bauelements 24 bereitgestellt.

Von dem Lotpad 31 gehen Durchkontaktierungen 5 aus, die sich zu der oberen Metallisierungsschicht 23 des keramischen Schaltungsträgers 260 erstrecken. Weiter gehen von den Lotpads 32, 23 Durchkontaktierungen 50 aus, die sich zu der Oberseite 242 des elektrischen Bauelements 24 erstrecken.

Die Figur 4 verdeutlicht mögliche Probleme, die bei der Herstellung einer Leiterplattenanordnung gemäß der Figur 1 entstehen können. So zeigt die Figur 4 zwei elektrische Module 2 (jeweils mit einem keramischen Schaltungsträger 260, einem elektrischen Bauelement 24 und einem Abstandshalter 29 in ähnlichem Aufbau wie in Bezug auf die Figur 2 erläutert), die nach dem Auflöten auf die Leiterplatte 1 leicht verkippt sind (beispielsweise um ± 50 µm). Die Verkippung kann dazu führen, dass in den Bereichen K das Vergussmaterial 7 auch die Unterseite der elektrischen Module 2 bedeckt. Dies ist allerdings zu vermeiden, weil hierdurch der thermische Übergang zwischen dem elektrischen Modul 2 und dem Kühlkörper 3 verschlechtert würde.

Die Figuren 5-7 erläutern ein Verfahren zur Herstellung einer Leiterplattenanordnung gemäß der Figur 1, wobei sichergestellt ist, dass auch bei einer verkippten Anordnung der elektrischen Module 2 an der Unterseite der Leiterplatte 1 die Vergussmasse 7 die Unterseite 22 des elektrischen Moduls nicht bedeckt.

Die Bereitstellung einer Vergussmasse erfolgt mittels Spritzpressen in einem Werkzeug 110. Dieses umfasst ein Formnest 140, in das eine Leiterplatte mit daran angeordneten elektrischen Modulen 2 einlegbar ist. In das Formnest 140 kann mittels Kanälen 120 und eine Presse 130 eine Formmasse 70 eingepresst werden.

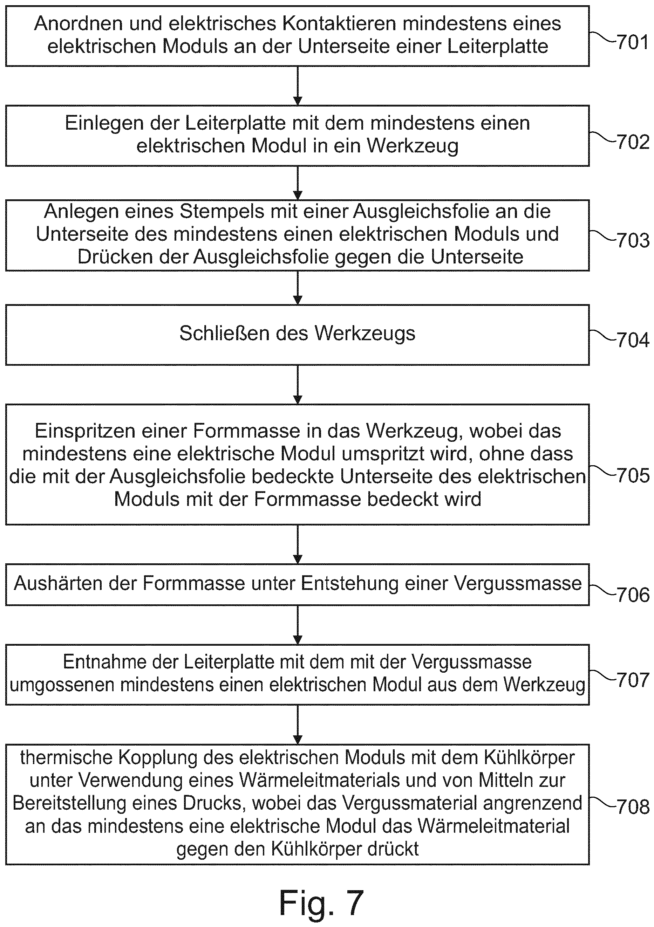

Die Figur 7 erläuterte das Verfahren. Zunächst werden in Schritt 701 mindestens ein elektrisches Modul bzw. mehrere elektrische Module 2 an der Unterseite einer Leiterplatte angeordnet. Dies erfolgt über einen Lötprozess. Anschließend wird in Schritt 702 die Leiterplatte mit den elektrischen Modulen 2 in das Werkzeug 110 eingelegt, nämlich in dessen Formnest 140. Dabei ist die Unterseite 22 der elektrischen Module in der Darstellung der Figur 5 nach oben gerichtet. Beispielsweise werden pro Nutzen 4 × 5 elektrische Module an der Leiterplatte angeordnet und in das Werkzeug 110 eingelegt.

Gemäß Schritt 703 wird anschließend jeweils ein Stempel mit einer Ausgleichsfolie an die Unterseite 22 der elektrischen Module 2 angelegt und über den Stempel die Ausgleichsfolie gegen die jeweilige Unterseite 22 gedrückt. In der Darstellung der Figur 5 wird dabei der Stempel mit der Ausgleichsfolie (nicht gesondert dargestellt) von oben auf die Unterseite 22 des jeweiligen Moduls 2 angelegt. Die Ausgleichsfolie ist beispielsweise eine Teflonfolie. Anschließend wird das Werkzeug 110 in Schritt 704 geschlossen. Es wird nun über die Kanäle 120 eine Formmasse unter Druck in das Werkzeug 110 eingespritzt und für eine bestimmte Zeit im Werkzeug belassen, Schritt 705. Dabei wird durch das Werkzeug 110 und dessen Formnest 140 das zu umspritzende Volumen exakt definiert. Die elektrischen Module 2 werden dabei umspritzt, ohne dass die jeweils mit einer Ausgleichsfolie bedeckte Unterseite mit der Formmasse bedeckt wird. Die Ausgleichsfolie verhindert dies selbst dann, wenn die Module 2 verkippt an der Leiterplatte angeordnet sind.

Während der Verweilzeit der Formmasse im Werkzeug 110 kommt es zum Vulkanisieren oder Aushärten der Formmasse, wobei die Vergussmasse entsteht, Schritt 706. Die Verweilzeit ist dabei von verschiedenen Faktoren abhängig wie zum Beispiel Harztyp, ggf. verwendeten Füllstoffen, Verarbeitungsdruck und Verarbeitungstemperatur. Ist die Verweilzeit beendet, wird das Werkzeug 110 geöffnet und wird die Leiterplatte mit den mit der Vergussmasse umgossenen elektrischen Modulen 2 aus dem Werkzeug 110 entnommen, Schritt 707.

Anschließend werden in Schritt 708 die elektrischen Module 2 mit einem Kühlkörper thermisch gekoppelt. Dies erfolgt unter Verwendung eines Wärmeleitmaterials und Mitteln zur Bereitstellung eines Drucks, entsprechend beispielsweise der Ausgestaltung der Figur 1. Dabei drückt das Vergussmaterial angrenzend an die elektrischen Module 2 das Wärmeleitmaterial gegen den Kühlkörper.

Das Ergebnis der Verwendung eines Stempels mit einer Ausgleichsfolie verdeutlicht die Figur 6, die ein einzelnes elektrisches Modul 2 darstellt, das in eine Vergussmasse 7 eingebettet ist. Das elektrische Modul ist beispielsweise entsprechend der Figur 2 ausgebildet und umfasst einen keramischen Schaltungsträger mit einer Metallisierungsschicht 27, die die Unterseite 22 des elektrischen Moduls 2 bildet. An den Rändern der Metallisierungsschicht 27 liegt jeweils ein kleiner vertikaler Versatz V1, V2 gegenüber der Oberfläche des Vergussmaterial 7 vor, der beispielsweise im Bereich zwischen 0,01 mm und 0,1 mm liegt. Dabei ist die Unterseite 22 des elektrischen Moduls 2 frei von Vergussmaterial 7. Der Versatz entsteht durch die Ausgleichsfolie, die während des Spritzpressens gegen die Unterseite 22 drückt.

## Patentansprüche

1. Leiterplattenanordnung, die aufweist:
- eine Leiterplatte (1) mit einer Oberseite (11) und einer Unterseite (12),
- mindestens ein elektrisches Modul (2) mit einer Oberseite (21) und einer Unterseite (22), das mit seiner Oberseite (21) an der Unterseite (12) der Leiterplatte (1) angeordnet ist,
- einen Kühlkörper (3),
- Mittel (5) zur Bereitstellung eines Drucks, mit dem das elektrische Modul (2) mit seiner Unterseite (22) gegen den Kühlkörper (3) gedrückt wird, und
- ein Wärmeleitmaterial (6), das zwischen der Unterseite (22) des elektrischen Moduls (2) und dem Kühlkörper (3) angeordnet ist,
**dadurch gekennzeichnet,**
**dass** das mindestens eine elektrische Modul (2) in ein Vergussmaterial (7) eingebettet ist, das mit der Unterseite (22) des elektrischen Moduls (2) abschließt, ohne die Unterseite (22) zu bedecken, wobei das Vergussmaterial (7) dazu vorgesehen und ausgebildet ist, angrenzend an das mindestens eine elektrische Modul (2) das Wärmeleitmaterial (6) gegen den Kühlkörper (3) zu drücken.

2. Leiterplattenanordnung nach Anspruch 1, **dadurch gekennzeichnet, dass** die Leiterplattenanordnung mehrere elektrische Module (2) aufweist, die in das Vergussmaterial (7) eingebettet sind, wobei das Vergussmaterial (7) dazu vorgesehen und ausgebildet ist, im Bereich (B) zwischen den elektrischen Modulen (2) das Wärmeleitmaterial (6) gegen den Kühlkörper (3) zu drücken.

3. Leiterplattenanordnung nach Anspruch 1 oder 2, **dadurch gekennzeichnet, dass** das Vergussmaterial (7) sich zumindest abschnittsweise bis an die Unterseite (12) der Leiterplatte (1) erstreckt.

4. Leiterplattenanordnung nach einem der vorangehenden Ansprüche, **dadurch gekennzeichnet, dass** das elektrische Modul (2) an seiner Oberseite (21) ausgebildete elektrische Lotpads (31-33) aufweist, die jeweils über eine Lotschicht mit einem zugeordneten elektrischen Lotpad (41-43) der Leiterplatte (1) in Kontakt stehen, wobei das Vergussmaterial (7) sich angrenzend an die Lotpads (31-33) auch im Spalt (9) zwischen der Unterseite (12) der Leiterplatte (1) und der Oberseite (21) des elektrischen Moduls (2) erstreckt.

5. Leiterplattenanordnung nach einem der vorangehenden Ansprüche, **dadurch gekennzeichnet, dass** das Vergussmaterial (7) solche Bereiche an der Unterseite der Leiterplatte umgibt und elektrisch isoliert, in denen die Leiterplatte (1) Durchkontaktierungen (85) ausbildet.

6. Leiterplattenanordnung nach einem der vorangehenden Ansprüche, **dadurch gekennzeichnet, dass** das Vergussmaterial (7) eine Härte aufweist, die größer ist als die Härte des Wärmeleitmaterials (6), und/oder ein Epoxidharz ist.

7. Leiterplattenanordnung nach einem der vorangehenden Ansprüche, **dadurch gekennzeichnet, dass** das mindestens eine elektrische Modul (2) durch Spritzpressen oder Spritzgießen in das Vergussmaterial (7) eingebettet worden ist.

8. Leiterplattenanordnung nach einem der vorangehenden Ansprüche, **dadurch gekennzeichnet, dass** das mindestens eine elektrische Modul (2) umfasst:
- einen keramischen Schaltungsträger (260), der eine isolierende Keramikschicht (26) und eine auf der Oberseite der Keramikschicht (26) angeordnete Metallisierungsschicht (23) aufweist,
- ein elektrisches Bauelement (24), das auf der Oberseite der Metallisierungsschicht (23) angeordnet und elektrisch mit dieser verbunden ist,
- wobei die Keramikschicht (26) oder eine auf der Unterseite der Keramikschicht (26) ausgebildete zweite Metallisierungsschicht (27) über das Wärmeleitmaterial (6) mit dem Kühlkörper (3) verbunden ist.

9. Leiterplattenanordnung nach Anspruch 8, **dadurch gekennzeichnet, dass** das elektrische Bauelement (24) ein Halbleiterbauelement, insbesondere ein Leistungshalbleiter ist.

10. Leiterplattenanordnung nach Anspruch 8 oder 9, **dadurch gekennzeichnet, dass** elektrische Kontakte des Moduls (2) mindestens eine erste Durchkontaktierung (5) umfassen, die sich von einem Lotpad (31) an der Oberseite (21) bis zu der ersten Metallisierungsschicht (23) erstreckt, sowie zweite und dritte Durchkontaktierungen (50) umfassen, die sich von anderen Lotpads (32, 33) an der Oberseite (21) zu entsprechenden Kontakten an der Oberseite (242) des elektrischen Bauelements (24) erstrecken.

11. Leiterplattenanordnung nach einem der vorangehenden Ansprüche, **dadurch gekennzeichnet, dass** das mindestens eine elektrische Modul (2) in einer Kavität (30) des Kühlkörpers (3) angeordnet ist.

12. Verfahren zur Herstellung einer Leiterplattenanordnung, das die Schritte umfasst:
- Anordnen (701) und elektrisches Kontaktieren mindestens eines elektrischen Moduls (2) an der Unterseite einer Leiterplatte (1),
- Einlegen (702) der Leiterplatte (1) mit dem mindestens einen elektrischen Modul (2) in ein Werkzeug (110),
- Anlegen (703) eines Stempels mit einer Ausgleichsfolie an die Unterseite (22) des mindestens einen elektrischen Moduls (2) und Drücken der Ausgleichsfolie gegen die Unterseite,
- Schließen (704) des Werkzeugs (110),
- Einspritzen (705) einer Formmasse in das Werkzeug (110), wobei das mindestens eine elektrische Modul (2) umspritzt wird, ohne dass die mit der Ausgleichsfolie bedeckte Unterseite (22) des elektrischen Moduls (2) mit der Formmasse bedeckt wird,
- Aushärten (706) der Formmasse unter Entstehung einer Vergussmasse (7),
- Entnahme (707) der Leiterplatte (1) mit dem mit der Vergussmasse (7) umgossenen mindestens einen elektrischen Modul (2) aus dem Werkzeug (110), und
- thermisches (708) Koppeln des mindestens einen elektrischen Moduls (2) mit einem Kühlkörper (3) unter Verwendung eines Wärmeleitmaterials (6) und von Mitteln (5) zur Bereitstellung eines Drucks, wobei das Vergussmaterial (7) angrenzend an das mindestens eine elektrische Modul (2) das Wärmeleitmaterial (6) gegen den Kühlkörper (3) drückt.

13. Verfahren nach Anspruch 12, **dadurch gekennzeichnet, dass** beim Einspritzen (705) der Formmasse in das Werkzeug (110) das mindestens eine elektrische Modul (2) dahingehend umspritzt wird, dass die Formmasse auch einen Spalt (9) zwischen der Unterseite der Leiterplatte (1) und der Oberseite des elektrischen Moduls (2) schließt.

14. Verfahren nach Anspruch 12 oder 13, **dadurch gekennzeichnet, dass** beim Einspritzen (705) der Formmasse in das Werkzeug (110) das mindestens eine elektrische Modul (2) dahingehend umspritzt wird, dass die Formmasse auch solche Bereiche an der Unterseite der Leiterplatte (1) umgibt und elektrisch isoliert, in denen die Leiterplatte Durchkontaktierungen (85) ausbildet.

15. Verfahren nach einem der Ansprüche 12 bis 14, **dadurch gekennzeichnet, dass** in einem Nutzen eine Mehrzahl von elektrischen Modulen (2) im Werkzeug gleichzeitig umspritzt wird.

## Claims

1. Printed circuit board arrangement having:
- a printed circuit board (1) with a top side (11) and a bottom side (12),
- at least one electrical module (2) with a top side (21) and a bottom side (22), which is arranged with its top side (21) on the bottom side (12) of the printed circuit board (1),
- a heat sink (3),
- means (5) for providing a pressure with which the electrical module (2) is pressed with its bottom side (22) against the heat sink (3), and
- a thermally conductive material (6) arranged between the bottom side (22) of the electrical module (2) and the heat sink (3),
**characterized in that**
the at least one electrical module (2) is embedded in a potting material (7) which is flush with the bottom side (22) of the electrical module (2) without covering the bottom side (22), wherein the potting material (7) is provided and formed to press the thermally conductive material (6) against the heat sink (3) adjacent to the at least one electrical module (2).

2. Printed circuit board arrangement according to Claim 1, **characterized in that** the printed circuit board arrangement has a plurality of electrical modules (2) which are embedded in the potting material (7), wherein the potting material (7) is provided and formed to press the thermally conductive material (6) against the heat sink (3) in the area (B) between the electrical modules (2).

3. Printed circuit board arrangement according to Claim 1 or 2, **characterized in that** the potting material (7) extends at least in sections to the bottom side (12) of the printed circuit **board** (1).

4. Printed circuit board arrangement according to one of the preceding claims, **characterized in that** the electrical module (2) has electrical solder pads (31-33) formed on its top side (21), which are each in contact with an associated electrical solder pad (41-43) of the printed circuit board (1) via a solder layer, wherein the potting material (7) extends adjacent to the solder pads (31-33) also in the gap (9) between the bottom side (12) of the printed circuit board (1) and the top side (21) of the electrical module (2).

5. Printed circuit board arrangement according to one of the preceding claims, **characterized in that** the potting material (7) surrounds and electrically insulates those areas on the bottom side of the printed circuit board in which the printed circuit board (1) forms vias (85).

6. Printed circuit board arrangement according to one of the preceding claims, **characterized in that** the potting material (7) has a hardness which is greater than the hardness of the thermally conductive material (6) and/or is an epoxy resin.

7. Printed circuit board arrangement according to one of the preceding claims, **characterized in that** the at least one electrical module (2) has been embedded in the potting material (7) by transfer moulding or injection moulding.

8. Printed circuit board arrangement according to one of the preceding claims, **characterized in that** the at least one electrical module (2) comprises:
- a ceramic circuit carrier (260) having an insulating ceramic layer (26) and a metallization layer (23) arranged on the top side of the ceramic layer (26),
- an electrical component (24) which is arranged on the top side of the metallization layer (23) and is electrically connected thereto,
- wherein the ceramic layer (26) or a second metallization layer (27) formed on the bottom side of the ceramic layer (26) is connected to the heat sink (3) via the thermally conductive material (6).

9. Printed circuit board arrangement according to Claim 8, **characterized in that** the electrical component (24) is a semiconductor component, in particular a power semiconductor.

10. Printed circuit board arrangement according to Claim 8 or 9, **characterized in that** electrical contacts of the module (2) comprise at least a first via (5) extending from a solder pad (31) on the top side (21) to the first metallization layer (23), and comprise second and third vias (50) extending from other solder pads (32, 33) on the top side (21) to corresponding contacts on the top side (242) of the electrical component (24).

11. Printed circuit board arrangement according to one of the preceding claims, **characterized in that** the at least one electrical module (2) is arranged in a cavity (30) of the heat sink (3).

12. Method for producing a printed circuit board arrangement comprising the steps of:
- arranging (701) and electrically contacting at least one electrical module (2) on the bottom side of a printed circuit board (1),
- inserting (702) the printed circuit board (1) with the at least one electrical module (2) into a mould (110),
- applying (703) a stamp with a compensating film to the bottom side (22) of the at least one electrical module (2) and pressing the compensating film against the bottom side,
- closing (704) the mould (110),
- injecting (705) a moulding compound into the mould (110), wherein the at least one electrical module (2) is overmoulded without the bottom side (22) of the electrical module (2) covered with the compensating film being covered with the moulding compound,
- curing (706) the moulding compound to generate a potting compound (7),
- removing (707) the printed circuit board (1) with the at least one electrical module (2) encapsulated with the potting compound (7) from the mould (110), and
- thermally (708) coupling the at least one electrical module (2) to a heat sink (3) using a thermally conductive material (6) and means (5) for providing a pressure, wherein the potting material (7) adjacent to the at least one electrical module (2) presses the thermally conductive material (6) against the heat sink (3).

13. Method according to claim 12, **characterized in that** when injecting (705) the moulding compound into the mould (110), the at least one electrical module (2) is overmoulded such that the moulding compound also closes a gap (9) between the bottom side of the printed circuit board (1) and the top side of the electrical module (2).

14. Method according to Claim 12 or 13, **characterized in that** when injecting (705) the moulding compound into the mould (110), the at least one electrical module (2) is overmoulded such that the moulding compound also surrounds and electrically insulates those areas on the bottom side of the printed circuit board (1) in which the printed circuit board forms vias (85).

15. Method according to one of Claims 12 to 14, **characterized in that** in one panel a plurality of electrical modules (2) are simultaneously overmoulded in the mould.

## Revendications

1. Ensemble carte de circuit imprimé comprenant :
- une carte de circuit imprimé (1) avec une face supérieure (11) et une face inférieure (12),
- au moins un module électrique (2) avec une face supérieure (21) et une face inférieure (22), qui est disposé avec sa face supérieure (21) sur la face inférieure (12) de la carte de circuit imprimé (1),
- un dissipateur thermique (3),
- des moyens (5) pour fournir une pression avec laquelle le module électrique (2) est pressé avec sa face inférieure (22) contre le dissipateur thermique (3), et
- un matériau conducteur de chaleur (6) disposé entre la face inférieure (22) du module électrique (2) et le dissipateur thermique (3),
**caractérisé en ce que**
l'au moins un module électrique (2) est scellé dans un matériau de scellement (7) qui se termine avec la face inférieure (22) du module électrique (2) sans recouvrir la face inférieure (22), ledit matériau de scellement (7) étant prévu et conçu pour presser le matériau conducteur de chaleur (6) contre le dissipateur thermique (3) de manière adjacente l'au moins un module électrique (2).

2. Ensemble carte de circuit imprimé selon la revendication 1, **caractérisé en ce que** l'ensemble carte de circuit imprimé présente plusieurs modules électriques (2) qui sont scellés dans le matériau de scellement (7), ledit matériau de scellement (7) étant prévu et conçu pour presser le matériau conducteur de chaleur (6) contre le dissipateur thermique (3) dans la zone (B) entre les modules électriques (2).

3. Ensemble carte de circuit imprimé selon la revendication 1 ou 2, **caractérisé en ce que** le matériau de scellement (7) s'étend au moins par sections jusqu'à la face inférieure (12) de la carte de circuit imprimé (1).

4. Ensemble carte de circuit imprimé selon l'une des revendications précédentes, **caractérisé en ce que** le module électrique (2) présente sur sa face supérieure (21) des plots de soudure électrique (31-33) formés qui sont chacun en contact avec un plot de soudure électrique associé (41-43) de la carte de circuit imprimé (1) par l'intermédiaire d'une couche de soudure, ledit matériau de scellement (7) s'étendant de manière adjacente aux plots de soudure (31-33) également dans la fente (9) entre la face inférieure (12) de la carte de circuit imprimé (1) et la face supérieure (21) du module électrique (2).

5. Ensemble carte de circuits imprimés selon l'une des revendications précédentes, **caractérisé en ce que** le matériau de scellement (7) entoure et isole électriquement les zones de la face inférieure de la carte de circuits imprimés dans lesquelles la carte de circuits imprimés (1) forme des vias (85).

6. Ensemble carte de circuit imprimé selon l'une des revendications précédentes, **caractérisé en ce que** le matériau de scellement (7) présente une dureté supérieure à la dureté du matériau conducteur de chaleur (6) et/ou est une résine époxy.

7. Ensemble carte de circuit imprimé selon l'une des revendications précédentes, **caractérisé en ce que** le au moins un module électrique (2) a été noyé dans le matériau de scellement (7) par moulage par injection ou par injection.

8. Ensemble carte de circuit imprimé selon l'une des revendications précédentes, **caractérisé en ce que** ledit au moins un module électrique (2) comprend :
- un support de circuit céramique (260) qui comprend une couche céramique isolante (26) et une couche de métallisation (23) disposée sur la face supérieure de la couche céramique (26),
- un composant électrique (24) qui est disposé sur la face supérieure de la couche de métallisation (23) et qui est relié électriquement à celle-ci,
- la couche céramique (26) ou une deuxième couche de métallisation (27) formée sur la face inférieure de la couche céramique (26) étant reliée au dissipateur thermique (3) par l'intermédiaire du matériau conducteur de chaleur (6).

9. Ensemble carte de circuit imprimé selon la revendication 8, **caractérisé en ce que** le composant électrique (24) est un composant semi-conducteur, en particulier un semi-conducteur de puissance.

10. Ensemble carte de circuit imprimé selon la revendication 8 ou 9, **caractérisé en ce que** les contacts électriques du module (2) comprennent au moins un premier via (5) s'étendant depuis un plot de soudure (31) sur la face supérieure (21) jusqu'à la première couche de métallisation (23), et comprennent des deuxième et troisième vias (50) s'étendant depuis d'autres plots de soudure (32, 33) sur la face supérieure (21) jusqu'à des contacts correspondants sur la face supérieure (242) du composant électrique (24).

11. Ensemble carte de circuit imprimé selon l'une des revendications précédentes, **caractérisé en ce que** l'au moins un module électrique (2) est disposé dans une cavité (30) du dissipateur thermique (3).

12. Procédé de fabrication d'un ensemble carte de circuit imprimé, comprenant les étapes suivantes :
- agencement (701) et mise en contact électrique d'au moins un module électrique (2) sur la face inférieure d'une carte de circuit imprimé (1),
- insertion (702) de la carte de circuit imprimé (1) avec l'au moins un module électrique (2) dans un outil (110),
- application (703) d'un poinçon comportant un film de compensation sur la face inférieure (22) de l'au moins un module électrique (2) et pression du film de compensation contre la face inférieure,
- fermeture (704) de l'outil (110),
- injection (705) d'une masse de moulage dans l'outil (110), ledit au moins un module électrique (2) étant surmoulé sans que la face inférieure (22) du module électrique (2) recouverte du film de compensation soit recouverte de la masse de moulage,
- durcissement (706) de la masse de moulage avec formation d'une masse de scellement (7),
- retrait (707) de la carte de circuit imprimé (1) avec l'au moins un module électrique (2) surmoulé de la masse de scellement (7) de l'outil (110), et
- couplage thermique (708) dudit au moins un module électrique (2) à un dissipateur thermique (3) en utilisant un matériau conducteur de chaleur (6) et des moyens (5) pour fournir une pression, ledit matériau de scellement (7) adjacent audit au moins un module électrique (2) pressant le matériau conducteur de chaleur (6) contre le dissipateur thermique (3).

13. Procédé selon la revendication 12, **caractérisé en ce que,** lors de l'injection (705) de la masse de moulage dans l'outil (110), l'au moins un module électrique (2) est surmoulé de telle sorte que la masse de moulage ferme également une fente (9) entre la face inférieure de la carte de circuit imprimé (1) et la face supérieure du module électrique (2).

14. Procédé selon la revendication 12 ou 13, **caractérisé en ce que,** lors de l'injection (705) de la masse de moulage dans l'outil (110), l'au moins un module électrique (2) est surmoulé de telle sorte que la masse de moulage entoure et isole électriquement également les zones de la face inférieure de la carte de circuit imprimé (1) dans lesquelles la carte de circuit imprimé forme des vias (85).

15. Procédé selon l'une des revendications 12 à 14, **caractérisé en ce qu'une** pluralité de modules électriques (2) sont surmoulés simultanément dans l'outil en une seule utilisation.
